# EUROPEAN PATENT APPLICATION

(11) **EP 0 599 592 A1**
(43) Date of publication of application: **01.06.1994**
(21) Application number: 93309313.0
(22) Date of filing: 23.11.1993
(51) Int. Cl.: H01L 21/90

(54) **Self-aligned via**

(30) Priority: 25.11.1992 US 981815
(71) Applicant: SGS-THOMSON MICROELECTRONICS, INC., Carrollton Texas 75006 (US)
(72) Inventor: Haslam, Michael E., Highland Village, Texas 75067 (US); Spinner, Charles R., III., Dallas, Texas 75244 (US)
(74) Representative: Palmer, Roger

(57) **Abstract**

A method is provided for a self-aligned via of a semiconductor integrated circuit, and an integrated circuit formed according to the same. A conductive bilayer (26,28) is formed over a conductive structure and a portion of a first underlying interlevel dielectric layer (24). The conductive bilayer (26,28) is then patterned and etched, wherein a pillar (29) is formed at an upper surface of the bilayer (26,28). A second interlevel dielectric layer (30) is formed adjacent to the pillar (29) and over the remaining bilayer (26,28). The pillar (29) forms a conductive material within a self-aligned via.

## Description

The present invention relates generally to semiconductor integrated circuit processing, and more specifically to self-aligned vias.

The trend to continue to miniaturize semiconductor integrated circuits to achieve submicron feature sizes and increase the number of devices fabricated on the integrated circuit has required smaller isolation areas between devices. In addition, step coverage has posed a major problem for integrated circuit manufacturers even into the late 1980s. Poor step coverage can be found at the sharp vertical step metal to substrate contacts, metal to metal vias, and metal crossovers. As dimensions shrink, conventional techniques used to improve step coverage fall short of expectations and are limited to stringent design criteria.

Forming reliable submicron contacts and vias for integrated circuit applications has received widespread attention in the microelectronics industry. Metal films, for example, are used extensively for surface wiring. The metallization process of wiring components together begins with etching contact openings or vias through the various layers down to the active regions within a semiconductor substrate, or to contact an underlying polycrystalline silicon or a metal interconnect layer. A conductive metal is then deposited over the surface of the wafer in a manner that provides good contact with the underlying active devices. Increasing chip density and smaller geometries have decreased the available area for surface wiring due to the need for a minimum enclosure of contacts and vias.

For example, conductive interconnect layers typically have an enlarged area in the layer itself at a location where a contact is to be made from a later formed interconnect layer. The enlarged area is commonly referred to as the enclosure. Recognizing that errors in mask alignment can shift a contact from a desired location, the enclosure accounts for errors in mask alignment by providing additional contact space. Thus, the enclosure ensures a contact will be made to an underlying interconnect layer.

A conflict arises, however, between the need for enclosures and the desire to reduce the chip sizes in integrated circuits. There generally needs to be a minimum amount of space between adjacent conductive elements. Enclosures in an interconnect layer force the distance between adjacent conductive elements to increase. Thus, the need for enclosures places restrictions on how small the size of an integrated circuit can be.

Errors in mask alignment can also cause problems during formation of contacts and vias. Some contacts and vias are formed directly above an underlying conductive interconnect layer, and ideally, the contact lies on or touches only the underlying conductive interconnect layer. Errors in mask alignment, however, allow for placement of the contact via to shift from the desired location. Formation of contacts and vias typically requires overetching an insulating layer to ensure all material is removed from the contacts and vias, thus, underlying layers may be damaged during formation of the contacts and vias.

Furthermore, this overetching combined with an error in mask alignment may create small geometric spaces between the conductive interconnect layer and the insulating layer. It is sometimes difficult to fill in those small geometric spaces. This may cause voids or other defects within the contact, thereby affecting the integrity of the contact and the reliability of the integrated circuit.

It is therefore an object of the this invention to provide a method of eliminating the need for enclosures in conductive interconnect layers.

It is a further object of this invention to provide a method of forming a self-aligned via or contact.

It is a further object of this invention to provide such a method which utilizes conventional process flows.

Other objects and advantages of the invention will be apparent to those of ordinary skill in the art having reference to the following specification together with the drawings.

The invention may be incorporated into a method for forming a semiconductor device structure, and the semiconductor device structure formed thereby. A first conductive layer is formed over a conductive structure and a portion of a first underlying interlevel dielectric layer. A second conductive layer is formed over the first conductive layer. The second conductive layer is then patterned and etched exposing a portion of the first conductive layer. This etching of the second conductive layer forms a pillar-like structure. A second interlevel dielectric layer is formed over the first conductive layer and adjacent to the second conductive layer or pillar-like structure forming the self-aligned via.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:

**Figures 1**-**4** are cross sectional views of the fabrication of a semiconductor integrated circuit according to a preferred embodiment of the present invention.

**Figures 5A-6B** are cross sectional views of the fabrication of a semiconductor integrated circuit according to an alternative preferred embodiment of the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

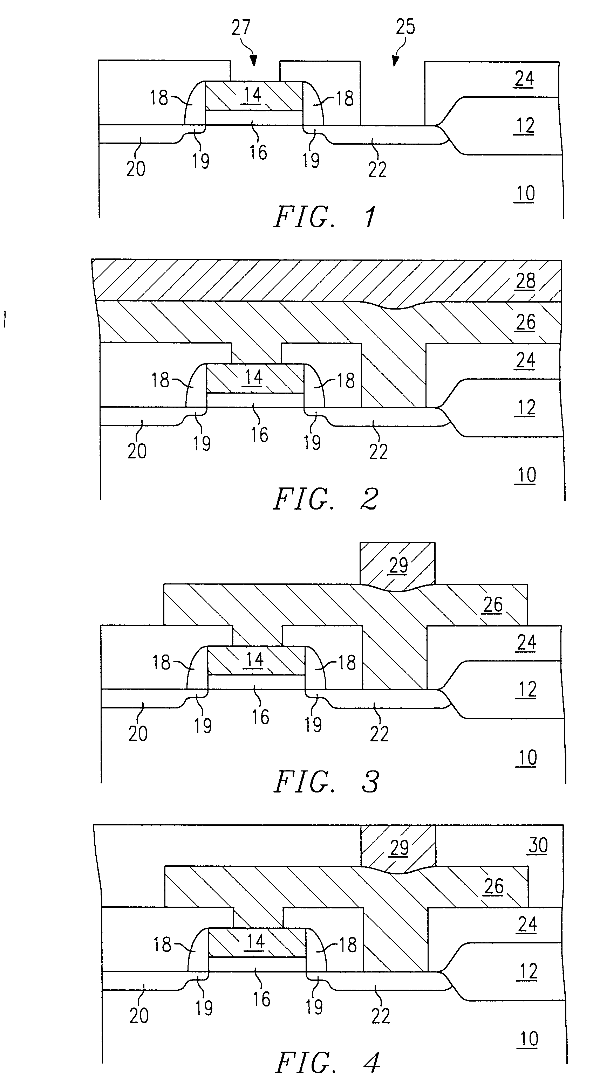

Referring to **Figure 1,** an integrated circuit is to be formed on a silicon substrate. A field oxide region 12 is generally formed in an area on the substrate as known in the art to separate active areas. A conductive structure such as a transistor is formed over a portion of the substrate 10. The transistor comprises gate electrode 14, preferably a doped polysilicon, which is formed over a gate oxide 16 as known in the art. The transistor typically also comprises oxide spacers 18, lightly doped drain regions 19 and more heavily doped source and drain regions 20 and 22. A first underlying interlevel dielectric layer 24 is formed over the conductive structure and field oxide region. The dielectric layer 24 is typically borophosphorous silicate glass (BPSG) or other reflow type dielectric having a thickness of between approximately 2000 to 8000 angstroms. A contact opening 25 is formed in the dielectric layer 24 exposing a portion of an underlying conductive structure, which, in the preferred embodiment, is source/drain region 22. An opening 27 may also be made to other conductive structures or other regions of the same conductive structure such as the gate 14 of the transistor, as shown.

Referring to **Figure 2,** a first conductive layer 26 is formed over the underlying first interlevel dielectric layer 24 and in the opening 25 contacting the source/drain region 22. If opening 27 is formed, layer 26 will also contact the gate 14. Conductive layer 26 is preferably an aluminum or refractory metal film formed to a thickness of between approximately 2000 to 12000 angstroms. Layer 26 may also be a doped polysilicon or other interconnect film such as a refractory metal nitride or refractory metal silicide. In other words, this process may be used typically with any materials suitable for forming contacts and vias.

At this stage, in the prior art, typically an interlevel dielectric layer would be formed over the region to be contacted, in this case, layer 26. A via would be formed in the dielectric layer and filled with a suitable conductive material for making contact to the underlying conductive region. Any errors in the mask alignment at this stage, however, would shift the contact via away from the desired location. For example, layer 26 would require a large region for enclosure of the via in order to take into account any misalignment of the via pattern and etch to the conductive layer pattern and etch. In addition, overectching of the interlevel dielectric to ensure that all material was removed from the contact via might damage underlying layers during the formation of the contact via. Voids and other defects may also be caused as a result of misalignment and overetching, thus reducing the integrity of the circuit and the reliability of the integrated circuit.

In the present invention, a second conductive layer 28 is next formed over the first conductive layer 26. Layer 28 is preferably formed from the same material as that used for layer 26. Layer 28 will have a thickness of between approximately 5000 to 20000 angstroms. The first and second conductive layers 26 and 28 thus form a conductive bilayer over the dielectric layer 24 and in the opening to the source/drain region 22.

Referring to **Figure** **3,** the second conductive layer is patterned and etched to form a conductive pillar region 29. This pillar region 29 will form the via contacting the lower conductive layer 26 and any subsequent conductive layers. The first conductive layer 26 is then patterned and etched, if necessary, according to methods known in the art. If layer 26 is patterned and etched, the pillar regions are also patterned and possibly etched again if any of the pillar region is exposed during the etching of the conductive layer 26. One of the features of the present invention is that the pillar region 29 exists prior to the patterning and etching of layer 26. This process defines the self-aligned via. There will be no effect if the pattern for the conductive layer 26 is misaligned from the pillar 29. If the pillar is etched again with the conductive layer, the alignment exactly matches. This self-aligned process eliminates the need for the enlarged enclosure in conductive layer 26, as would be required in the prior art described above.

Referring to **Figure 4,** an interlevel dielectric layer 30 is then formed over the pillar region 29 and the first conductive layer 26 not covered by the pillar region 29. The interlevel dielectric layer 30 may also be formed over the underlying dielectric layer 24 which is exposed after the first conductive layer 26 is patterned and etched. Layer 30 typically comprises an undoped silicon glass and is formed to a thickness of between approximately 4000 to 20000 angstroms. The interlevel dielectric layer 30 is partially etched back to expose an upper surface of the pillar region 29, as shown. One of the key features of the present invention it that this pillar region now forms the self-aligned via through the interlevel dielectric layer 30. The second conductive layer is typically patterned and etched so that the pillar is formed substantially over the underlying conductive structure to which it needs to make contact. In addition, the surface of the pillar region 29 is substantially planar thus providing a smoother surface for subsequent layers.

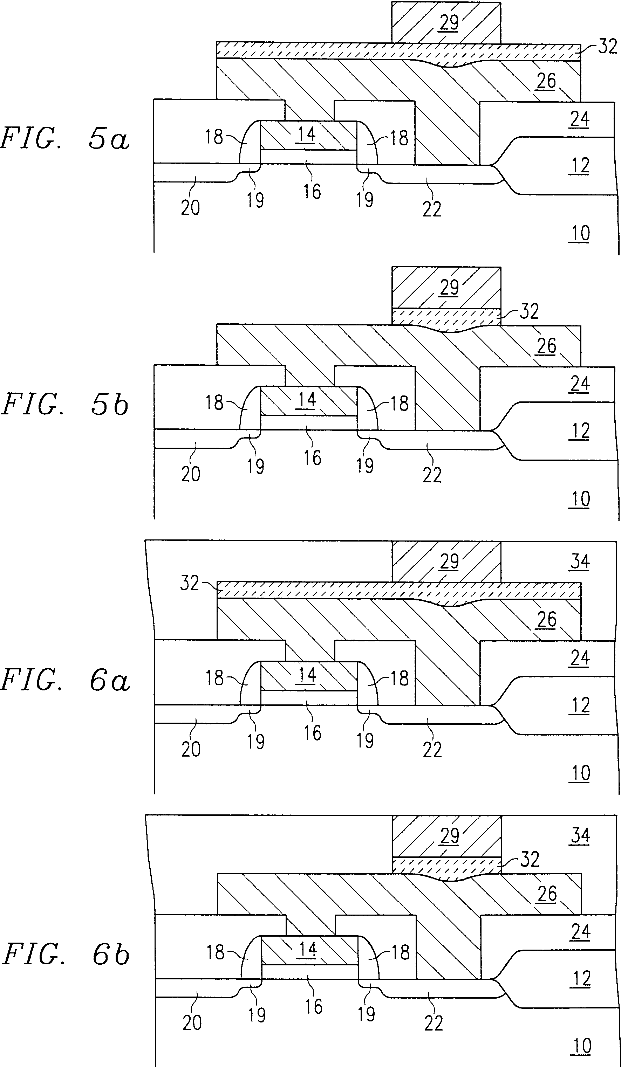

Referring to **Figure 5A,** an alternative preferred embodiment is shown. An interconductive layer 32 is formed over the first conductive layer 26 before the second conductive layer 28 is formed. Layer 32 will be formed to a thickness of between approximately 100 to 2000 angstroms. Layer 32 acts as an etch stop for the via etch of the second conductive layer 28 which forms the pillar or via 29. Interconductive layer 32 may be patterned and etched to remain disposed over the first conductive layer 26 and under any subsequently formed interlevel dielectric layer. Alternatively, after the pillar region 29 is formed, the interconductive layer 32 may be etched to remain only under the pillar 29, as shown in **Figure** **5B.** The interconductive layer 32 may be formed from any material that will act as an etch stop for the second conductive layer 28 which forms the pillar or via 29. For example, layer 32 may be an anti-fuse material such as an amorphous silicon. Layer 32 may also be another conductive layer such as a refractory metal nitride or another refractory metal such as a refractory metal silicide.

Referring to **Figure 6A,** the interlevel dielectric layer 34 is formed, as described above, over the pillar region 29, interconductive layer 32 and the underlying dielectric layer 24 not covered by the first conductive layer 26. Referring to **Figure 6B,** the interlevel dielectric layer 34 is also formed over the first conductive layer if the interconductive layer 32 is etched away to remain only under the pillar region 29. As described above, this pillar region 29, including the interconductive layer, now forms the self-aligned via in the interlevel dielectric layer 30.

While the invention has been particularly shown and described with reference to a preferred embodiment, it will be understood by those skilled in the art that various changes in form and detail may be made therein without departing from the spirit and scope of the invention.

## Claims

1. A method of forming a self aligned via for a semiconductor integrated circuit, comprising the steps of:
forming a first conductive layer over a conductive structure and a portion of a first interlevel dielectric layer;
forming a second conductive layer over the first conductive layer;
patterning and etching the second conductive layer exposing a portion of the first conductive layer; and,
forming a second interlevel dielectric layer over the first conductive layer and adjacent to the second conductive layer.

2. The method of claim 1, wherein the first and second conductive layers comprise one of: a metal, a polysilicon, a refractory metal, a refractory metal nitride or a refractory metal silicide.

3. The method of claim 1, wherein the conductive structure is a source/drain region of a transistor or a gate electrode of a transistor.

4. The method of claim 1, further comprising the step of:
patterning and etching the first conductive layer to expose a portion of the first interlevel dielectric layer before the second interlevel dielectric layer is formed.

5. The method of claim 1, further comprising the step of:
forming an interconductive layer over the first conductive layer before the second conductive layer is formed.

6. The method of claim 4, wherein the interconductive layer comprises a refractory metal.

7. The method of claim 1, wherein the remaining portion of the second conductive layer after etching is formed substantially over the underlying conductive structure.

8. The method of claim 1, wherein the second interlevel dielectric is further formed over the second conductive layer.

9. A method of forming a self aligned via for a semiconductor integrated circuit, comprising the steps of:
forming a conductive bilayer over a conductive structure and a portion of a first interlevel dielectric layer;
patterning and partially etching the conductive bilayer;
wherein a pillar is formed at an upper surface of the bilayer;
and
forming a second interlevel dielectric layer adjacent to the pillar and over the remaining bilayer.

10. The method of claim 9, wherein the step of forming a bilayer further comprises the steps of:
forming a first conductive layer over the first interlevel dielectric layer and the conductive structure; and
forming a second conductive structure over the first conductive structure.

11. The method of claim 10, further comprising the step of:
forming an interconductive layer over the first conductive layer before the second conductive layer is formed, wherein the interconductive layer acts as an etch stop during the partial etching of the bilayer.

12. The method of claim 5 or claim 11, further comprising the step of:
patterning and etching the interconductive layer after the second conductive layer is etched, wherein the interconductive layer remains only under the second conductive layer.

13. The method of claim 5 or claim 11, wherein the interconductive layer comprises an anti-fuse layer.

14. The method of claim 11, wherein the interconductive layer comprises a refractory metal nitride.

15. A structure consisting of a portion of a semiconductor device, comprising:
a conductive bilayer disposed over a conductive structure and a portion of a first interlevel dielectric layer, wherein the bilayer has an upwardly projecting pillar; and
a second interlevel dielectric layer disposed adjacent to the pillar and over the remaining portion of the bilayer.

16. The structure of claim 15, wherein the pillar is disposed substantially over the conductive structure.

17. The structure of claim 15, further comprising an inter bilayer film disposed between the pillar and the remaining portion of the conductive bilayer.

18. The structure of claim 16, wherein the inter bilayer film comprises an anti-fuse layer.
